# EUROPEAN PATENT APPLICATION

(11) **EP 1 223 615 A1**
(43) Date of publication of application: **17.07.2002**
(21) Application number: 01100537.8
(22) Date of filing: 10.01.2001
(51) Int. Cl.: H01L 21/768, H05K 3/10, H01L 21/00

(54) **A method for producing a structure using nanoparticles**

(71) Applicant: Eidgenössische Technische Hochschule Zürich, 8092 Zürich (CH)
(72) Inventor: Grigoropoulos, Constantine P., Berkeley, Berkeley, CA 94720-1740 (US); Bieri, Nicole Renée, Sonneggstrasse 3, 8092 Zürich (CH); Poulikakos, Dimos, Sonneggstrasse 3, 8092 Zürich (CH)
(74) Representative: Blum, Rudolf Emil Ernst

(57) **Abstract**

For forming a fine structure of a desired material, nanoparticles of the same material are prepared in a suspension. A layer (4) of the suspension is applied to a substrate (1). Part of the layer (4) is exposed to laser light for melting the nanoparticles at least partially. Upon solidification, the molten particles are sintered together to form the desired structure. Due to the low melting point of nanoparticles as compared to the melting point of bulk material, this procedure avoids damage to the substrate and provides a better control over the structure generation process. It can be used for generating metallic and non-metallic structures on various substrates.

## Description

The present invention relates to a method for producing a structure using nanoparticles according to the preamble of claim 1 as well as to structures produced by this method and an application thereof.

The term "nanoparticles" designates particles having a diameter well in the submicron range. It has been know that such particles start to exhibit thermophysical properties substantially different from bulk materials. In particular, the melting point starts to decrease substantially for particle diameters e.g. below 100 nm, and in particular below 10 nm. Nanoparticles of gold show e.g. a melting point of 300 to 400 °C at a diameter of 2.5 nm while the bulk melting point of gold is 1063 °C.

In WO 00/10197 this effect is exploited for producing copper structures on a semiconductor wafer at low temperatures. A suspension of copper nanoparticles in a liquid is applied to a semiconductor chip. After evaporation of the solvent, nanoparticles are concentrated in recesses in the wafer surface and the wafer is heated above the particles' melting point to sinter or melt them. This method takes advantage of the comparatively low melting point of the particles, but it requires the presence of suitable recesses in the surface of the substrate.

The problem to be solved by the present invention is to provide a method for preparing fine structures using nanoparticles without requiring dedicated recesses on the substrate.

This problem is solved by the method of claim 1. Accordingly, the nanoparticles are molten at least in part by exposition to laser light, whereupon they are solidified for forming a solid structure in those places where the nanoparticles where heated up by the laser. This allows to use the laser to define the structure.

Preferably, the laser light is focussed in a focal point, which is moved in respect to the substrate, thereby forming a solidified line of bulk material from the nanoparticles.

Preferably, the nanoparticles are mixed with a liquid to form a suspension which can then be applied to the substrate, e.g. using an ink jet printer device.

The average diameter of the nanoparticles should be sufficiently small for reducing the melting point of the nanoparticles substantially below the bulk melting point. For most materials the average diameter should be less than 100 nm, in particular less than 10 nm, preferably between 2 nm and 5 nm. The nanoparticles can be of any material being suited for sintering or re-melting upon laser irradiation. In particular, they can be of a metal, such as gold.

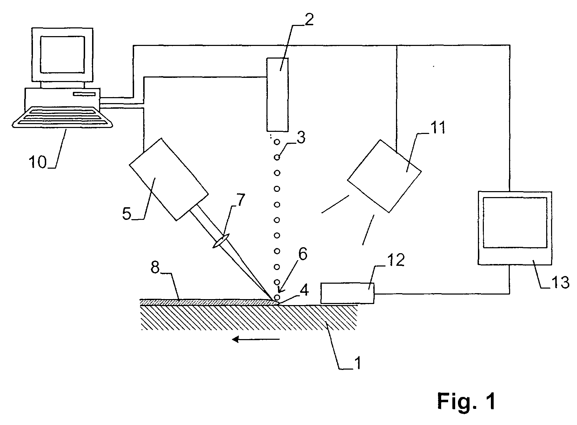

Further preferred embodiments of the invention as well as applications thereof are disclosed in the dependent claims as well as in the following description. This description makes reference to Fig. 1, which shows a schematic drawing of a set-up for preparing a structure from nanoparticles.

Fig. 1 shows a diagram of a preferred apparatus for generating a structure from nanoparticles on a substrate 1, which can e.g. be a semiconductor wafer. A droplet generator 2 is provided for generating a controlled, directed series of drops 3 of a solid in liquid suspension directed onto the substrate. The suspension consists, in a preferred embodiment, of gold nanoparticles in an organic solvent.

The drops 3 are deposited on substrate 1 to form a layer 4 thereon.

The beam of a laser 5 is focussed in a focal point 6 on layer 4 using suitable focusing optics 7. The radiation energy of the laser light is absorbed by the nanoparticles, leading to a temperature increase above the melting point of the particles. The generated heat evaporates the solvent and melts the nanoparticles at least partially. When the heated nanoparticles are moved away from focal point 6, they cool down and solidify, leaving a solid structure 8.

While drops 3 are being deposited and laser 5 sinters or melts the particles into the solid structure, substrate 1 is being moved in respect to laser 5 and droplet generator 2. For this purpose, substrate 1 can e.g. be displaced by a positioning stage (not shwon), while laser 5 and droplet generator 2 remain stationary.

Preferably, the drops 3 generated by droplet generator 2 impinge on substrate 1 at the position of focal point 6, which makes it possible to create a line shaped structure 8 along any direction.

Once structure 8 has solidified, any excess solvent and not sintered nanoparticles are removed, e.g. by washing. This post-processing step can be avoided by depositing a line-structure that is smaller than the focal point of the laser so that the deposit solvent is evaporated in its entirety.

The operation of drop generator 2 and laser 5 and the displacement of substrate 1 are preferably controlled by a computer 10.

For monitoring the formation of the structure 8, the apparatus can further be provided with a monitoring system, which comprises a stroboscope 11, a camera with microscope lens 12 and a framegrabber 13. The stroboscopic light source 11 is triggered e.g. in synchronicity with the release of the drops 3, thereby generating a standing picture of the drops arriving at focal point 6 in framegrabber 13.

In the following, some aspects of the procedure are described in more detail.

### Nanoparticles, suspension:

The nanoparticles are preferably made of metal for forming a metallic structure. Gold has been found an especially suited material. As mentioned above, nanoparticles of gold show a melting point of 300 to 400°C at a diameter of 2.5 nm, which allows to form the desired structure at moderate temperatures.

The nanoparticles can also be made of a non-metallic material. In particular, the present method also allows to form ceramic structures. Of particular interest are superconductive ceramics, which could be sintered with the present process without creating the excessive thermal stress that is responsible for the prohibitingly brittle behaviour of superconductive ceramic components.

A preferred "solvent" or, more accurately, suspension-fluid for the nanoparticles is toluene. Toluene has good wetting properties and its viscosity is suited for generating small droplets. Further preferred solvents are other organic solvents, such as terpineol or xylene, or water.

### Droplet generator:

The droplet generator 2 can be any device suited for a controlled generation of the drops 3. Preferred is the application of a drop on demand device where a volume of the suspension is compressed by piezoelectric or thermal compression, thereby squirting one or more drops of the suspension through an opening onto the substrate. Piezoelectric compression or any other isothermal mechanical or electromechanical compression is preferred because it is suited for any suspension, while the evaporation process required in thermal compression (bubble jet method) can lead to contamination or clogging.

### Laser light:

The wavelength of the laser light and the intensity at focal point 6 have to be selected according to the properties of the nanoparticles as well as according to the desired heating rate. For best efficiency, at least 80% of the laser light should be absorbed in layer 4.

Preferably, the exponential absorption coefficient of the suspension for the laser light is even higher, at least 0.1 µm⁻¹, in particular at least 1 µm⁻¹, which ensures that most of the laser light is absorbed close to the surface of layer 4. It has been found that the heat is transported through the whole depth of the layer, sintering or melting all nanoparticles in focal point 6.

The wavelength of the laser light is preferably chosen to be in a region of high absorption of the suspension. The laser can either be operated in continuous or pulsed mode.

The diameter of focal point 6 must be sufficiently small for forming even the finest parts of the desired structure. A typical diameter is less than 500 µm, preferably less than 100 µm.

Typical average laser powers at a displacement speed in the order of 1 mm/s are in the order of 0.2 W to 2 W with a focal point diameter of 100 µm, resulting in intensities in the order of 25 to 250 W/mm².

### Example:

In a preferred example, gold nanoparticles with a mean average size of 2 to 5 nm were suspended in toluene. The mass-fraction of gold in the solution was 40% of the total weight.

Droplets were generated with a drop on demand piezoelectric jetting device from Microfab Inc. This piezoelectric device consists of a reservoir and a capillary glass tube filled with the suspension. A piezoelectric material is deposited on the outer surface of the glass capillary. When a voltage pulse series is applied to the piezoelectric material, a volumetric change is induced to the fluid (and a corresponding pressure wave is generated within it) and a drop 3 will be ejected.

The drops 3 were deposited to form layer 4 as a line on a silicon wafer substrate by moving the substrate continuously at a speed of 1 mm/s with a positioning stage. The deposited layer 4 was simultaneously cured by light from an Argon ion laser at a wavelength of 488 nm, where the slurry had an absorption of less than 1 µm⁻¹. The focal point 6 was located right behind the point where the drops impinged on the substrate 1. It had a diameter of approximately 100 µm.

After cooling, the remaining structure consisted of solid, continuous, electrically conducting gold lines with an electrical conductance at least as good as that of bulk gold. The lines had a typical width of 60 - 100 µm.

In the example mentioned above, substrate 1 was a silicon wafer. Other types of substrates can be used as well, such as substrates of glass or ceramic.

For expediting the melting or sintering of the nanoparticles, the substrate and/or the suspension can be heated to a temperature below the melting point of the nanoparticles, thereby decreasing the amount of energy required from the laser.

In the above examples, the liquid layer 4 has been formed by applying the drops 3 generated by droplet generator 2. Instead of a drop-wise application of the suspension, other coating methods, such as spin coating, can be used for producing layer 4. Again, the laser light is then used for forming the desired structure.

Instead of being present in the form of a regular suspension (i.e. a solid in liquid suspension), layer 4 may also be formed by a "solid suspension", i.e. the nanoparticles can be suspended in a solid matrix, e.g. by solidifying the "solvent" after spin coating by temperature decrease or partial evaporation. Alternatively, the nanoparticles can be suspended in a gas.

The heating and curing of the nanoparticles with laser light can take place while layer 4 is being formed, such as shown in the example above. It can also take place after the formation of layer 4.

The method described here can be used for forming any type of structure. Examples are conducting lines for interconnections on or to a semiconductor chip or for connecting a semiconductor chip to a substrate or to connector pins, metallic or non-metallic parts of Micro Electromechanical Systems (MEMS) or superconducting structures.

A primary application of the present invention is for constructing gold lines for interconnections in electronics manufacturing, ranging from chip assembly packaging to flat panel display construction. The critical benefit to be harvested from the low melting and bonding temperatures of the gold nanoparticles is twofold: First, the printing of gold microline interconnections with a at-demand microdroplet generation technique is possible because one deals with a room temperature nanosuspension facilitating the application of piezoelectric ceramics with Curie temperatures of only a few hundred degrees Celsius. This would be impossible with molten gold at temperatures exceeding 1063 °C. Second, at the droplet deposition end, excess thermal stress and melting or burning of sensitive chip structures can be avoided. The method can be used under normal atmosphere environment yielding a fast, user friendly and cost effective interconnection manufacturing process appropriate for use in combination with a variety of delicate substrate materials.

## Claims

1. A method for producing a structure on a substrate (1) comprising the step of applying nanoparticles of a material to form the structure (1) and **characterized by** the steps of melting the nanoparticles at least partially by exposition to laser light and solidifying the molten nanoparticles for forming the structure (8).

2. The method of claim 1 comprising the steps of focussing the laser light in a focal point (6) and translating the focal point (6) in respect to the substrate (1) for forming the structure.

3. The method of claim 2 wherein the focal point (6) has a diameter of less than 500 µm, in particular less than 100 µm.

4. The method of one of the claims 2 or 3 wherein the substrate (1) is moved for generating the structure.

5. The method of one of the preceding claims comprising the step of applying a suspension of the nanoparticles in a liquid to the substrate (1), and in particular of forming a layer (4) of the suspension on the substrate (1).

6. The method of claim 5 wherein the suspension is applied in drops (3) to the substrate (1) using a droplet generator (2).

7. The method of claim 6 comprising the step of generating the drops (3) by compressing a volume of the suspension by piezoelectric or thermal compression and thereby squirting the drops through an opening onto the substrate.

8. The method of one of the claims 2 to 4 and of one of the claims 5 to 7 wherein the drops (3) are deposited on the substrate (1) at the focal point (6).

9. The method of one of the claims 5 to 8 wherein the liquid is selected from the group comprising toluene, terpineol, xylene and water.

10. The method of one of the claims 5 to 9 wherein an exponential absorption coefficient of the laser light in the suspension is at least 0.1 µm⁻¹, in particular at least 1 µm⁻¹.

11. The method of one of the claims 5 to 10 wherein the suspension is deposited as a layer (4) on the substrate (1), wherein at least 80% of the laser light is absorbed in the layer (4).

12. The method of one of the preceding claims wherein the nanoparticles are of a metal, in particular of gold.

13. The method of one of the preceding claims wherein an average diameter of the nanoparticles is sufficiently small for reducing a melting point of the nanoparticles substantially below a bulk melting point of the material, and in particular wherein the average diameter is less than 100 nm, in particular less than 10 nm, preferably between 2 nm and 5 nm.

14. The method of one of the preceding claims wherein the structure is a superconducting ceramic material.

15. The method of one of the preceding claims further comprising the step of observing the production of the structure using a stroboscopic light source (11) and a camera (12), and in particular wherein the stroboscopic light source (11) is triggered in synchronicity with the application of drops (3) of a suspension of the nanoparticles to the substrate (1).

16. A structure producible by the method of one of the preceding claims.

17. Application of the method of one of the claims 1 - 15 for the production of electrical interconnections on and/or to semiconductor chips.
